# EUROPÄISCHE PATENTANMELDUNG

(11) **EP 3 859 294 A1**
(43) Veröffentlichungstag der Anmeldung: **04.08.2021**
(21) Anmeldenummer: 21154333.5
(22) Anmeldetag: 29.01.2021
(51) Int. Cl.: G01L 1/16, G01L 5/167

(54) **STRUKTURIERTES, PIEZOELEKTRISCHES SENSORELEMENT**

(30) Priorität: 29.01.2020 AT 500692020
(71) Anmelder: Piezocryst Advanced Sensorics GmbH, 8020 Graz (AT)
(72) Erfinder: Schricker, Alexander, 8046 Graz (AT); Kröger, Dietmar, 8010 Graz (AT); Dreisiebner, Franz, 8010 Graz (AT)
(74) Vertreter: Hartinger, Mario

(57) **Zusammenfassung**

Die Erfindung betrifft ein strukturiertes, piezoelektrisches Sensorelement sowie einen piezoelektrischen Sensor. Um eine Möglichkeit zur verlässlichen Messung verschiedener Messgrößen mit einem Sensor zu schaffen, der eine geringe Fehleranfälligkeit bei möglichst geringem Platzbedarf aufweist, weist das Sensorelement mehrere piezoelektrische, vorzugsweise monokristalline, flächig ausgebildete Messelemente (10₁, ..., 10ᵢ) auf, die zwischen Gehäuseelementen (20) eines piezoelektrischen Sensors lagerbar und mechanisch vorspannbar sind, wobei die Messelemente (10₁, ..., 10ᵢ) in einer gemeinsamen Ebene angeordnet sind, und wobei die Vorzugsrichtungen der Messelemente (10₁, ..., 10ᵢ) eine definierte Ausrichtung relativ zu der gemeinsamen Ebene, in der die Messelemente (10₁, ..., 10ᵢ) angeordnet sind, und relativ zueinander aufweisen, wobei das Sensorelement eine Lochscheibe mit einem Durchgangsloch (40) ausbildet und die Messelemente (10₁, ..., 10ᵢ) um das Durchgangsloch (40) angeordnet sind.

Zur Messung eines Temperatureintrags erstrecken sich die Vorzugsrichtungen mindestens zwei der Messelemente (10₁, ..., 10ᵢ) radial von dem Durchgangsloch (40).

## Beschreibung

Die vorliegende Erfindung betrifft ein strukturiertes, piezoelektrisches Sensorelement gemäß dem Gegenstand von Anspruch 1, sowie einen piezoelektrischen Sensor gemäß dem Gegenstand von Anspruch 8.

Piezoelektrische Sensoren werden für eine Vielzahl von Messanwendungen zur Erfassung von Drücken oder Kräften eingesetzt. Piezoelektrische Sensoren enthalten ein oder mehrere piezoelektrische Sensorelemente, die aus einem piezoelektrischen Material gebildet sind. Zur Messung wird der direkte Piezoeffekt dieser Materialien ausgenutzt: Bei einer durch eine mechanische Krafteinwirkung hervorgerufenen Verformung eines Sensorelements aus piezoelektrischem Material werden an der Oberfläche des Sensorelements elektrische Ladungen erzeugt, wobei der erzeugte Ladungsbetrag proportional zur relativen Deformation des piezoelektrischen Sensorelements ist. Durch Messung der erzeugten Ladungen kann die auf das piezoelektrische Sensorelement einwirkende Kraft ermittelt werden.

Piezoelektrische Sensoren eignen sich dabei für eine breite Palette von Anwendungen, da sie relativ robust sind und eine hohe Empfindlichkeit und Linearität über einen großen Messbereich aufweisen. In einigen Anwendungsbereichen ist es wünschenswert, mehrere Kraftrichtungen mit einem Sensor erfassen zu können. So werden beispielsweise in der Robotik sogenannte Sechs-Achsen Kraft-/Momentensensoren eingesetzt. Diese werden zwischen steuerbare Roboterelemente und einen Effektor montiert und können sowohl Kräfte als auch Drehmomente in allen drei Raumrichtungen erfassen. Für derartige Anwendungen ist neben der Robustheit des Sensors auch die Größe des Sensors ein entscheidender Parameter, da der Platz für die Unterbringung eines Sensors häufig begrenzt ist.

Die Dokumente EP 0459068 A1, WO 2013188989 A1 und CH 500602 A zeigen Sensorelemente, die als Lochscheibe mit einem Durchgangsloch ausgeführt sind. Die Messelemente sind hierbei so angeordnet, dass ihre Vorzugsrichtungen entweder in x- und y-Richtung oder tangential angeordnet sind.

Aus der gattungsgemäßen DE 1929478 B2 ist ein als Lochscheibe mit einem Durchgangsloch ausgebildetes Sensorelement mit mehreren Messelementen bekannt, wobei die Vorzugsrichtungen der Messelemente entweder alle tangential oder alle parallel zur x-Achse ausgerichtet sind.

Im Lichte der obigen Ausführungen ist es Aufgabe der vorliegenden Erfindung, eine Möglichkeit zur verlässlichen Messung verschiedener Messgrößen mit einem Sensor zu schaffen, der eine geringe Fehleranfälligkeit bei möglichst geringem Platzbedarf aufweist.

Diese Aufgabe wird durch ein strukturiertes, piezoelektrisches Sensorelement nach Anspruch 1 sowie einen piezoelektrischen Sensor nach Anspruch 9 gelöst. Ebenso wird die Aufgabe gelöst durch die Verwendung von Sensorelementen wie in den Ansprüchen 12 bis 15 spezifiziert. Vorteilhafte Weiterbildungen ergeben sich aus den Unteransprüchen.

Die Aufgabe der Erfindung wird insbesondere gelöst durch ein strukturiertes, piezoelektrisches Sensorelement aufweisend mehrere piezoelektrische, vorzugsweise monokristalline, flächig ausgebildete Messelemente, die zwischen Gehäuseelementen eines piezoelektrischen Sensors lagerbar und mechanisch vorspannbar sind, wobei die Messelemente im Wesentlichen in einer gemeinsamen Ebene angeordnet sind, und wobei die Vorzugsrichtungen der Messelemente eine definierte Ausrichtung relativ zu der gemeinsamen Ebene, in der die Messelemente angeordnet sind, und relativ zueinander aufweisen.

Ein wesentlicher Punkt der Erfindung besteht darin, ein flächiges Sensorelement für einen piezoelektrischen Sensor aus mehreren Messelementen zu bilden, die eine unterschiedliche Vorzugsrichtung aufweisen. Dadurch ist es möglich, verschiedene Kraftrichtungen mit einem Sensorelement zu erfassen. Die Messelemente des Sensorelements werden hierbei im Wesentlichen in einer gemeinsamen Ebene angeordnet. Unter einer Anordnung im Wesentlichen in einer Ebene bzw. einer Anordnung in einer Ebene ist im Rahmen der vorliegenden Erfindung eine Anordnung zu verstehen, bei der die flächig ausgebildeten Messelemente nicht in einer Richtung senkrecht zu der flächigen Erstreckungsrichtung überlappen, also eine Anordnung, in der die flächig ausgebildeten Messelemente nicht gestapelt werden sondern nebeneinander angeordnet werden. Es ist nicht erforderlich, dass die Messelemente exakt in einer gemeinsamen Ebene zur Anordnung kommen. Eine Anordnung der Messelemente mit einem geringfügigen Versatz zwischen den Messelementen in einer Richtung senkrecht zu der flächigen Erstreckungsrichtung ist im Sinne der vorliegenden Erfindung ebenfalls eine Anordnung im Wesentlichen in einer gemeinsamen Ebene, solange die Messelemente in Draufsicht nicht überlappen.

Somit wird ein Sensorelement geschaffen, das nur einen geringen Platzbedarf aufweist, da das Sensorelement in einer Richtung senkrecht zu seiner flächigen Erstreckungsrichtung nur einen geringen Platzbedarf aufweist.

Die Messelemente weisen jeweils eine definierte Vorzugsrichtung auf. Die Vorzugsrichtung ist durch die Kristallstruktur des piezoelektrischen Kristallmaterials festgelegt und gibt eine Belastungsrichtung an, in welcher die meisten Ladungen in dem Piezokristall erzeugt werden. Eine Kraftbeaufschlagung eines piezoelektrischen Messelements parallel zur Vorzugsrichtung führt zu einem signifikant stärkeren Messsignal als eine Kraftbeaufschlagung in anderen Richtungen. Dadurch ist es möglich, gezielt piezoelektrische Messelemente zu fertigen, die für eine Belastungsrichtung empfindlich sind, indem das Messelement so aus einem Block von piezoelektrischem Kristallmaterial geschnitten wird, dass die Vorzugsrichtung die gewünschte Orientierung relativ zu den Oberflächen des Messelements hat.

Durch die Bereitstellung von Messelementen mit definierten Vorzugsrichtungen ist es möglich, verschiedene Kraftrichtungen mit dem Sensorelement zu erfassen. Es ist hierbei bevorzugt, dass das Sensorelement Messelemente aufweist, die mindestens zwei verschiedene Vorzugsrichtungen aufweisen. Besonders bevorzugt ist eine Konfiguration, bei der die Messelemente mindestens zwei zueinander senkrechte Vorzugsrichtungen aufweisen. Dies erlaubt die Erfassung von mindestens zwei verschiedenen Kraftrichtungen. Da die Messelemente in einer gemeinsamen Ebene angeordnet sind, kann somit ein flaches, piezoelektrisches Multifunktions-Sensorelement geschaffen werden.

Die Formgebung der Messelemente unterliegt abgesehen von der flächigen Ausgestaltung keinen besonderen Beschränkungen. Die Anordnung der Messelemente in einer gemeinsamen Ebene kann dadurch erreicht werden, dass die Messelemente aneinander angrenzend zu einem Sensorelement zusammengesetzt werden. Ebenso ist es im Rahmen der vorliegenden Erfindung möglich, dass die Messelemente mit einem Abstand zueinander in einer gemeinsamen Ebene angeordnet sind, indem sie beispielsweise in eine vorgefertigte Maske in einem Gehäuseelement eingesetzt werden, mit der die Positionierung der Messelemente innerhalb des Gehäuses festgelegt wird. Als Sensorelement wird im Rahmen der vorliegenden Erfindung die Gesamtheit der Messelemente in einer gemeinsamen Ebene bezeichnet.

Die Messelemente sind zwischen Gehäuseelementen eines Sensors vorspannbar. Die Gehäuseelemente und die Konfiguration des entsprechenden Sensors unterliegen keinen besonderen Einschränkungen. Die Messelemente sind ebenso zur Vorspannung zwischen Gehäuseelementen eines geschlossenen Sensorgehäuses geeignet wie zur Vorspannung zwischen Spannelementen, die nicht Teil eines Gehäuses sein müssen, wie es beispielsweise bei Accelerometern üblich ist.

Gemäße der vorliegenden Erfindung bildet das Sensorelement eine Lochscheibe mit einem Durchgangsloch aus, wobei die Messelemente um das Durchgangsloch angeordnet sind. Eine derartige Konfiguration des Sensorelements ermöglicht die Konstruktion eines Sensors mit einem Durchgangsloch. Damit kann der Sensor auf eine Welle oder eine Schraube aufgesteckt werden und zur Messung von Kräften eingesetzt werden, die an der Welle oder Schraube oder zwischen den über die Welle oder Schraube verbundenen Komponenten auftreten.

Erfindungsgemäß erstrecken sich die Vorzugsrichtungen mindestens zwei der Messelemente, insbesondere von allen Messelementen, radial von dem Durchgangsloch. In einer besonders bevorzugten Variante sind die Vorzugsrichtungen zweier Messelemente, die sich radial von dem Durchgangsloch erstrecken, nicht parallel zueinander und insbesondere zueinander senkrecht.

Mit dieser Ausführungsform lässt sich ein Multifunktionssensor bilden. Zum einen können mit einem Sensor, der ein derartiges Sensorelement enthält, die auf jedes Messelement wirkenden Radialkräfte gemessen werden, indem die Signale jedes Messelements separat erfasst und ausgelesen werden. Sind die Vorzugsrichtungen zweier Messelemente, die sich radial von dem Durchgangsloch erstrecken, zueinander senkrecht, können insbesondere Radialkräfte in der Ebene, in der die Messelemente angeordnet sind, in zwei orthogonalen Richtungen erfasst werden.

Weiterhin erlaubt diese Konfiguration des Messelements die Messung eines Temperatureintrags eines Elements, das sich durch das Durchgangsloch erstreckt.

Der Temperatureintrag kann gemessen werden, indem die Signale aller Messelemente aufsummiert werden. Thermische Ausdehnungen des Elements, das sich durch das Durchgangsloch erstreckt, führen zu einer Kraftbeaufschlagung der Messelemente in Radialrichtung. Durch das Aufsummieren der Signale aller Messelemente wird richtungsunabhängig die thermische Ausdehnung des

Es ist ferner bevorzugt, dass die Messelemente so geformt sind, dass sie derart aneinander angrenzend anordenbar sind, dass die Orientierung und/oder Position der Messelemente jeweils durch die angrenzenden Messelemente festgelegt ist.

Um die Messelemente mit definierter Vorzugsrichtung zu einem Sensorelement zusammenzusetzen, ist es erforderlich, neben der relativen Positionierung auch die Orientierung der Messelemente präzise festzulegen, da die Orientierung der Vorzugsrichtung der Messelemente innerhalb des Sensorelements bestimmt, für welche Krafteinwirkungsrichtungen die Messelemente empfindlich sind. Geringfügige Fehlausrichtungen der Messelemente können bereits zu einer signifikanten Verschlechterung des Messsignals führen. Sind die Messelemente so geformt, dass sie in einer gemeinsamen Ebene derart aneinander angrenzend anordenbar sind, dass die Orientierung und/oder Position der Messelemente durch die angrenzenden Messelemente festgelegt ist, kann eine korrekte Positionierung der Messelemente innerhalb des Sensorelements auf einfache Weise sichergestellt werden. Die Messelemente müssen beim Zusammenbau des Sensorelements lediglich aneinander angrenzend zusammengesetzt werden, um ihre korrekte Position und/oder Orientierung innerhalb des Sensorelements sicherzustellen.

Besonders bevorzugt ist eine Formgebung der Messelemente derart, dass die Position und/oder Orientierung der Messelemente durch die Form der Messelemente eindeutig festgelegt ist. Dies kann beispielsweise dadurch erreicht werden, dass die Messelemente an den Seiten, die an ein benachbartes Messelement angrenzen, aufeinander abgestimmte Ausrichtungshilfen aufweisen. Die Ausrichtungshilfen können beispielsweise durch komplementäre Ein- und Ausbuchtungen vorgesehen sein, derart, dass die Messelemente formschlüssig in einer Ebene anordenbar sind. Dies stellt sicher, dass sich die Messelemente mit korrekter Position und Orientierung zu dem Sensorelement zusammensetzen lassen.

In einer bevorzugten Ausführungsform der vorliegenden Erfindung erstrecken sich die Vorzugsrichtungen der Messelemente parallel zu der gemeinsamen Ebene, in der die Messelemente angeordnet sind. Mit einer derartigen Konfiguration lassen sich mehrere Kraftrichtungen innerhalb der gemeinsamen Ebene ermitteln. Ist das Sensorelement als Lochscheibe ausgebildet und die Messelemente um das Durchgangsloch angeordnet, kann das Sensorelement auf einem Element wie beispielsweise einer Welle angeordnet werden, die sich durch das Durchgangsloch erstreckt. Liegen die Vorzugsrichtungen der Messelemente parallel zu der gemeinsamen Ebene, lassen sich Kräfte erfassen, die eine orthogonale Komponente zu dem im Durchgangsloch angeordneten Element aufweisen. Dies ermöglicht sowohl eine Erfassung von Scherkräften tangential zu dem Element als auch die Erfassung von Kräften in einer radialen Richtung des Elements.

In einer weiteren möglichen Ausführungsform ist es bevorzugt, dass das Sensorelement zwei Messelemente aufweist, deren Vorzugsrichtungen senkrecht zueinander sind. Es ist insbesondere bevorzugt, dass das Sensorelement aus zwei Messelementen besteht, deren Vorzugsrichtungen senkrecht zueinander sind. Damit kann ein robuster und einfacher Multifunktionssensor geschaffen werden, der zwei verschiedene Kraftkomponenten erfassen kann. Ist das Sensorelement als Lochscheibe mit Durchgangsloch ausgebildet, erstrecken sich in einer möglichen Ausführungsform die Vorzugsrichtung mindestens zweier Messelemente radial von dem Durchgangsloch. Damit ist die Vorzugsrichtung des dritten Messelements senkrecht zur Vorzugsrichtung einer der beiden ersten Messelemente und damit entweder tangential zu oder ebenfalls radial von dem Durchgangsloch. Mit einem derartigen Sensor können dementsprechend entweder sowohl Scherkräfte als auch Radialkräfte oder nur Radialkräfte an einem Element erfasst werden, das sich durch das Durchgangsloch des Sensorelements erstreckt.

In einer weiteren möglichen Ausführungsform des Sensorelements weisen die um das Durchgangsloch angeordneten Messelemente mindestens zwei Vorzugsrichtung parallel zu der gemeinsamen Ebene, in der die Messelemente angeordnet sind, und mindestens eine Vorzugsrichtung senkrecht zu der gemeinsamen Ebene, in der die Messelemente angeordnet sind, auf. Bevorzugt können sich auch alle Vorzugsrichtungen, die parallel zu der gemeinsamen Ebene, in der die Messelemente angeordnet sind, liegen, radial von dem Durchgangsloch erstrecken und mindestens eine Vorzugsrichtung senkrecht zu der gemeinsamen Ebene, in der die Messelemente angeordnet sind, liegen. Die Verwendung eines derartigen Sensorelements in einem Sensor erlaubt sowohl die Messung von Kraftkomponenten senkrecht zu der Erstreckungsebene des Sensorelements als auch eine Messung von Kraftrichtungen innerhalb der Ebene des Sensorelements.

Es ist dabei besonders bevorzugt, dass die Vorzugsrichtungen der um das Durchgangsloch angeordneten Messelemente abwechselnd eine Vorzugsrichtung parallel und eine Vorzugsrichtung senkrecht zu der gemeinsamen Ebene der Messelemente aufweisen. Insbesondere bevorzugt ist es ferner, dass mindestens ein, insbesondere mindestens zwei, Messelement eine Vorzugsrichtung tangential zu dem Durchgangsloch aufweist und mindestens zwei Messelemente eine Vorzugsrichtung aufweisen, die sich radial von dem Durchgangsloch erstrecken.

Wird ein derartiges Sensorelement verwendet, kann ein Sensor geschaffen werden, mit dem sowohl Scherkräfte als auch Radial- und Axialkräfte eines Elements gemessen werden können, das sich durch das Durchgangsloch erstreckt. Enthält das Sensorelement mehrere Messelemente, deren Vorzugsrichtungen sich radial von dem Durchgangsloch erstrecken und nicht parallel zueinander sind, kann aus der Summe dieser Signale zudem ein Temperatureintrag des Elements erfasst werden, das sich durch das Durchgangsloch erstreckt. Insgesamt wird somit die Bildung eines Multifunktionssensors ermöglicht, der Kräfte in mehrere, vorzugsweise alle Raumrichtungen, sowie Temperatureinträge erfassen kann.

In einer weiteren, bevorzugten Ausführungsform der vorliegenden Erfindung weist mindestens ein Messelement eine oder mehrere Ausnehmungen zum Abbau von mechanischen Spannungen auf, die das Messelement in Messbereiche unterteilen, die durch Verbindungsbereiche miteinander verbunden sind. Es hat sich gezeigt, dass piezoelektrische Messelemente, da sie häufig aus einem kristallinen Material gefertigt sind, anfällig für Rissbildungen bei mechanischer (und /oder thermischer) Belastung sind. Die Gefahr von Rissbildung steigt mit zunehmender Größe der Messelements. Durch das kontrollierte Einbringen von Ausnehmungen in piezoelektrische Messelemente kann ein effektiver Abbau von mechanischen Spannungen ermöglicht werden, ohne dass dies eine nennenswerte Auswirkung auf die Messqualität hat. Durch das Vorsehen von Ausnehmungen wird das Messelement in Messbereiche unterteilt, die durch Verbindungsbereiche miteinander verbunden sind. Verspannungen des Messelements, die beispielsweise durch die mechanische Vorspannung aufgrund des Einbaus in ein Sensorgehäuse oder durch thermische Verspannungen induziert werden, können über die durch die Ausnehmungen gebildeten Zwischenräume zwischen den Messbereichen abgeleitet werden, so dass es zu keinem Bruch des Messelements kommt. Hierdurch kann die Messqualität des Sensorelements verbessert und eine gleichbleibende Messqualität sichergestellt werden.

Selbst wenn es in den Messelementen zur Rissbildung kommt, kann eine Verschlechterung der Messqualität entscheidend reduziert werden, weil durch die Ausbildung der Ausnehmungen die Messelemente in kleinere Messbereiche unterteilt werden, die bei Rissbildung entsprechend kleinere Bruchflächen ausbilden. Die durch die Rissbildung entstehenden Flächen, an denen sich leitfähige chemische Gruppen anlagern können, die zu einer Drift des Messsignals führen, sind dementsprechend ebenfalls kleiner, so dass insgesamt selbst im Falle einer Rissbildung die resultierende Drift wesentlich verringert wird.

Der durch die Ausnehmungen erzielbare Spannungsabbau ist umso ausgeprägter, je größer die Tiefe der Ausnehmungen ist. Die Ausnehmungen sind vorzugsweise so ausgebildet, dass sie sich durch die gesamte Dicke des Messelements hindurch erstrecken. Die Ausnehmungen können beispielsweise mittels eines spanenden Fertigungsverfahrens ausgebildet werden, oder mittels Laserschneiden oder Ätzen in das Messelement eingebracht werden. Die Ausnehmungen sind insbesondere in einer Ebene normal zur Krafteinleitung angeordnet.

Unter mechanischen Spannungen sind im Rahmen der vorliegenden Erfindung neben rein mechanischen Spannungen auch thermisch induzierte Spannungen zu verstehen, die schlussendlich ebenfalls in mechanischen Spannungen resultieren.

Es ist ferner bevorzugt, dass die Messelemente aus Galliumorthophosphat oder Lithiumniobat oder Kalzium Tantal Gallium Silikat (CTGS) gebildet sind. Galliumorthophosphat ist besonders geeignet für Hochtemperaturanwendungen, da es sich durch eine hohe und von der Temperatur weitgehend unabhängige piezoelektrische Empfindlichkeit auszeichnet. Lithiumniobat und CTGS zeichnen sich unter anderem durch seine hohe mechanische und chemische Stabilität aus.

Die Aufgabe der Erfindung wird ferner gelöst durch einen piezoelektrischen Sensor, aufweisend mindestens ein Sensorelement der oben beschriebenen Art, das zwischen zwei Sensorgehäuseelementen gelagert und zwischen den Sensorgehäuseelementen vorgespannt ist.

Mit einem derartigen piezoelektrischen Sensor können die Vorteile erzielt werden, die obenstehend im Zusammenhang mit den Sensorelementen beschrieben wurden. Durch die Integration mehrerer Messelemente mit verschiedenen Vorzugsrichtungen in das Sensorelement lässt sich ein Sensor ausbilden, der bei geringem Platzbedarf die Messung mehrerer Messgrößen ermöglicht, und der durch die Verwendung piezoelektrischer Messelemente eine hohe Messgenauigkeit und eine geringe Fehleranfälligkeit aufweist.

In einer bevorzugten Ausführungsform ist jedes Messelement in Kontakt mit einer Elektrode zur Abnahme von Messsignalen. Da die Messelemente flächig ausgebildet sind, ist die Elektrode zur Abnahme von Messsignalen vorzugsweise in flächigem Kontakt mit einer der beiden Oberflächen der Messelemente. Die Elektrode kann fest auf die Messelemente aufgebracht, beispielsweise aufgedruckt oder aufgedampft sein. Alternativ kann die Elektrode durch eine elektrisch leitende Schicht wie eine Metallfolie oder eine dünne Metallschicht ausgebildet sein, die auf eine Fläche der Messelemente aufgelegt wird. Weiterhin kann die Elektrode auf eine isolierende Schicht, beispielsweise aus Keramik oder Saphir, aufgebracht sein, die dann mit der Elektrodenseite auf die Messelemente aufgelegt wird. Dabei kann die Elektrode entsprechend der Struktur der Messelemente strukturiert sein.

Es kann jedem Messelement eine separate Elektrode zugeordnet sein, um eine unabhängige Auswertung der Signale jedes Messelements zu ermöglichen. Ebenso können mehrere Messelemente einer Elektrode zugeordnet sein, indem beispielsweise die Elektrode so geformt ist, dass sie mit mehreren Messelementen in Kontakt steht. Dadurch werden die von den Messelementen generierten Ladungen auf die gemeinsame Elektrode aufsummiert. Insbesondere durch die Aufbringung der Elektroden auf eine isolierende Schicht ist es möglich, Leiterbahnen auszugestalten, die auch eine Summierung von Ladungen erlauben, die an nicht aneinander angrenzenden Messelementen generiert werden.

Insbesondere bei den oben beschriebenen Konfigurationen des Sensorelements, die die Messung mehrerer Kraftrichtungen durch das Auslesen einzelner Messelemente erlauben, ist eine Konfiguration des Sensors bevorzugt, bei der jedem Messelement eine separate Elektrode zugeordnet ist. Wird nur ein Summensignal der Messelemente benötigt, wie beispielsweise bei Verwendung des Sensors für eine Messung des Temperatureintrags, kann es aus konstruktiven Gründen bevorzugt sein, eine Elektrode vorzusehen, die mit allen Messelementen in Kontakt steht, deren Signale aufsummiert werden sollen.

Gemäß einer weiteren bevorzugten Ausführungsform weist der Sensor ein Paar von Sensorelementen auf, die übereinander angeordnet sind, wobei eine Schicht von Elektroden zwischen den Sensorelementen angeordnet ist. Die Konfiguration der Sensorelemente ist vorzugsweise aufeinander abgestimmt, indem die Messelemente in dem Paar von Sensorelementen ebenfalls paarweise vorgesehen sind, so dass jedes Messelement des einen Sensorelements über einem entsprechenden Messelement des anderen Sensorelements angeordnet ist und dazwischen eine gemeinsame Elektrode angeordnet ist. Vorzugsweise sind die Vorzugsrichtungen und Formen der einander zugeordneten Messelemente ebenfalls aufeinander abgestimmt. In einer besonders bevorzugten Ausführungsform sind die Sensorelemente des Paars bezüglich der zwischenliegenden Schicht von Elektroden spiegelbildlich ausgebildet.

Die Konfiguration des Sensors mit einem Paar von Sensorelementen mit gemeinsam genutzter Elektrodenfläche erlaubt es, die Signale der Paare von Messelementen der jeweiligen Sensorelemente auf eine gemeinsame Elektrode zu summieren. Dadurch wird die Stärke des Messsignals erhöht. Die der Elektrodenschicht abgewandten Flächen der Sensorelemente können in dieser Anordnung über das Sensorgehäuse auf ein gemeinsames Potential gelegt werden. Ebenso ist es möglich, die Ladungen, die an den der Elektrodenschicht abgewandten Flächen der Messelemente erzeugt werden, über eine weitere, vom Sensorgehäuse elektrisch isolierte Elektrodenschicht abzuleiten.

Nachfolgend wird die Erfindung auch hinsichtlich weiterer Merkmale und Vorteile beschrieben, die anhand der Figuren näher erläutert werden.

Hierbei zeigen:
- Fig. 1: eine schematische Ansicht eines strukturierten piezoelektrischen Sensorelements gemäß einer Ausführungsform der vorliegenden Erfindung mit zwei Messelementen, das in ein Gehäuseelement eingesetzt ist;
- Fig. 2: eine schematische Ansicht eines strukturierten piezoelektrischen Sensorelements gemäß einer weiteren Ausführungsform der vorliegenden Erfindung mit vier Messelementen, das in ein Gehäuseelement eingesetzt ist;
- Fig. 3: eine schematische Ansicht des strukturierten piezoelektrischen Sensorelements aus Fig. 2 mit aufgebrachten Elektroden;
- Fig. 4: eine schematische Ansicht einer Modifikation des strukturierten piezoelektrischen Sensorelements aus Fig. 2 mit strukturierten Messelementen;
- Fig. 5: eine schematische Ansicht eines strukturierten piezoelektrischen Sensorelements gemäß einer weiteren Ausführungsform der vorliegenden Erfindung mit acht Messelementen, das in ein Gehäuseelement eingesetzt ist;
- Fig. 6: eine schematische Ansicht eines strukturierten piezoelektrischen Sensorelements gemäß einer weiteren Ausführungsform der vorliegenden Erfindung mit ebenfalls acht Messelementen, das in ein Gehäuseelement eingesetzt ist;
- Fig. 7: eine Modifikation des strukturieren, piezoelektrischen Messelements aus Fig. 5 mit Ausrichtungshilfen;
- Fig. 8: eine Modifikation des strukturieren, piezoelektrischen Messelements aus Fig. 6 mit Ausrichtungshilfen;
- Fig. 9: einen Schnitt durch einen Sensor mit einem Paar von Sensorelementen gemäß einer der Figuren 1 bis 8.

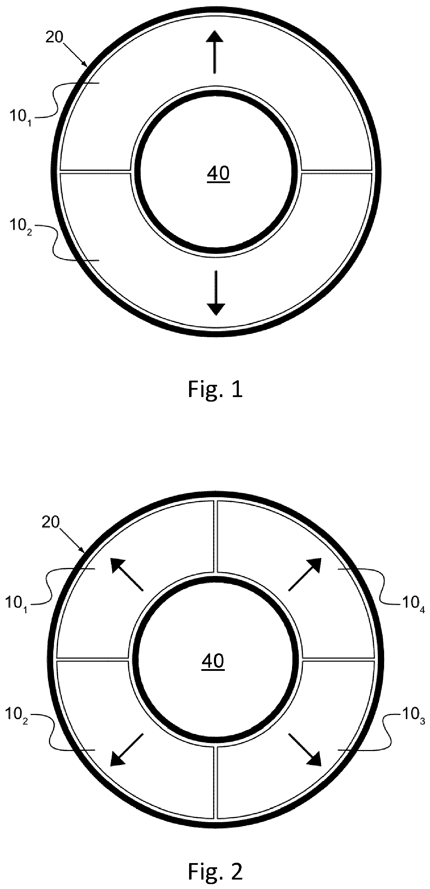

Fig. 1 zeigt eine schematische Ansicht eines strukturierten piezoelektrischen Sensorelements gemäß einem ersten Ausführungsbeispiel der vorliegenden Erfindung. Das Sensorelement weist mehrere Messelemente 10₁, 10₂ auf, die aus einem piezoelektrischen Material gebildet sind, vorzugsweise aus einem monokristallinen Material wie Galliumorthophosphat oder Lithiumniobat oder CTGS.

Die Messelemente 10₁, 10₂ weisen eine flächige, scheibenartige Konfiguration auf. In Fig. 1 ist eine der beiden flächigen Seiten der Messelemente 10₁, 10₂ in Draufsicht gezeigt Die Messelemente 10₁, 10₂ sind in einer gemeinsamen, parallel zur Bildebene verlaufenden Ebene angeordnet und weisen keine Überlappung in Draufsicht auf.

Die beiden Messelemente 10₁ und 10₂ weisen unterschiedliche Vorzugsrichtungen auf, die jeweils eine definierte Ausrichtung relativ zu der gemeinsamen Ebene, in der die Messelemente 10₁, 10₂ angeordnet sind, und relativ zueinander aufweisen. Die Vorzugsrichtungen der Messelemente 10₁, 10₂ sind durch Pfeile angezeigt. Die Vorzugsrichtungen beider Messelemente 10₁, 10₂ erstrecken sich parallel zu der Ebene, in der die Messelemente 10₁, 10₂ angeordnet sind. Das Messelement 10₁ weist eine Vorzugsrichtung auf, die parallel zu der Vorzugsrichtung des Messelements 10₂ ist.

Die Messelemente 10₁, 10₂ sind mit den flächigen Seiten zwischen zwei Gehäuseelementen eines Sensors anordenbar, die den beiden flächigen Seiten der Messelemente 10₁, 10₂ zugewandt sind, so dass eine auf die Gehäuseelemente ausgeübte Kraft auf die Messelemente 10₁, 10₂ übertragen wird. In Fig. 1 ist ein Gehäuseelement 20 gezeigt, in das die Messelemente 10₁, 10₂ eingelegt sind. Die Form der Messelemente 10₁, 10₂ ist an die Form des Gehäuseelements 20 angepasst. Die Messelemente 10₁, 10₂ bilden zusammen ein Sensorelement aus, das eine lochscheibenartige Form aufweist. Die Messelemente 10₁, 10₂ sind um das Durchgangsloch 40 herum angeordnet. Das Gehäuseelement 20 ist an die Form des Sensorelements angepasst und ebenfalls lochscheibenartig ausgebildet, so dass sowohl das Sensorelement als auch das Gehäuseelement 20 ein gemeinsames Durchgangsloch 40 aufweisen.

Die Vorzugsrichtung des Messelements 10₁ erstreckt sich radial von dem Durchgangsloch 40. Die Vorzugsrichtung des Messelements 10₂ erstreckt sich ebenfalls radial von dem Durchgangsloch 40. Wird das Sensorelement in einem Sensor verwendet, der um ein (nicht gezeigtes) Element herum angeordnet ist, das sich durch das Durchgangsloch 40 erstreckt, können mit den Messelementen 10₁ und 10₂ bezüglich des Durchgangslochs 40 in radialer Richtung wirkende Kräfte erfasst werden, also Radialkräfte, die an dem Element in dem Durchgangsloch 40 auftreten. Bei Auftreten einer Radialkraft an dem Element in dem Durchgangsloch 40 in Richtung der Vorzugsrichtung der Messelemente 10₁ und 10₂ werden Ladungen an den Messelementen 10₁ und 10₂ erzeugt, die über eine erste und eine zweite (beide nicht gezeigt) Elektrode, die an den Messelementen 10₁ und 10₂ angeordnet sind, abgegriffen werden können.

Fig. 2 zeigt ein weiteres Ausführungsbeispiel eines strukturierten piezoelektrischen Sensorelements gemäß der vorliegenden Erfindung. Das Sensorelement ist wiederum lochscheibenartig geformt und weist vier Messelemente 10₁, 10₂, 10₃, 10₄ auf. Die Messelemente 10₁, 10₂, 10₃, 10₄ sind in einem Gehäuseelement 20 angeordnet und um ein gemeinsames Durchgangsloch 40 des Sensorelements und des Gehäuseelements 20 angeordnet.

Die Vorzugsrichtungen der Messelemente 10₁, 10₂, 10₃, 10₄ wiesen eine definierte Ausrichtung relativ zu der gemeinsamen Ebene der Messelemente 10₁, 10₂, 10₃, 10₄ und relativ zueinander auf. Die Vorzugsrichtungen aller Messelemente 10₁, 10₂, 10₃, 10₄ sind parallel zu der gemeinsamen Ebene der Messelemente 10₁, 10₂, 10₃, 10₄, also parallel zu der Erstreckungsebene des Sensorelements ausgerichtet. Ferner erstrecken sich alle Vorzugsrichtungen radial von dem Durchgangsloch 40. In der in Fig. 2 gezeigten Konfiguration sind zudem die Vorzugsrichtungen der Messelemente 10₁ und 10₃ senkrecht zu den Vorzugsrichtungen der Messelemente 10₂ und 10₄.

Mit dem in Fig. 2 gezeigten Sensorelement lassen sich Radialkräfte an einem in dem Durchgangsloch 40 angeordneten Element in mehreren Richtungen erfassen, indem die Signale der Messelemente 10₁, 10₂, 10₃, 10₄ einzeln erfasst werden. Werden die Signale der Messelemente 10₁ und 10₂ summiert, lässt sich eine Radialkraft erfassen, die in Fig. 2 nach links wirkt. Analog kann durch Summierung der Signale der Messelemente 10₃ und 10₄ eine Radialkraft erfasst werden, die in Fig. 2 nach rechts wirkt, also in eine Richtung wirkt, die der vektoriellen Addition der Vorzugsrichtungen der Messelemente entspricht, deren Signale summiert werden.

Werden die Signale aller vier Messelemente 10₁, 10₂, 10₃, 10₄ summiert, erhält man ein richtungsunabhängiges Signal, das die Ausdehnungsunterschiede zwischen der Ober- und der Unterseite der Messelemente 10₁, 10₂, 10₃, 10₄ widerspiegelt. Damit kann auch ein Ausdehnungsunterschied eines Elements, das in dem Durchgangsloch 40 angeordnet ist, in einer Richtung senkrecht zu dem Durchgangsloch 40 erfasst werden. Die Summe der Signale aller vier Messelemente 10₁, 10₂, 10₃, 104 kann somit zur Erfassung eines Temperatureintrags des im Durchgangsloch 40 befindlichen Elements verwendet werden - bei Erhöhung der Temperatur des Elements auf einer Seite oberhalb bzw. unterhalb der Bildebene in Fig. 2 dehnt sich das Element auf dieser Seite aus, was zu einem entsprechenden Ausdehnungsunterschied zwischen der Ober- und Unterseite der Messelemente 10₁, 10₂, 10₃, 10₄ führt und als entsprechendes Signal in der Summe der Signale der Messelemente 10₁, 10₂, 10₃, 10₄ sichtbar wird.

Zur Summierung der Signale kann jedem Messelement 10₁, 10₂, 10₃, 10₄ eine separate, nicht gezeigte Elektrode zugeordnet werden und die Signale, die mit den jeweiligen Elektroden von den Messelementen 10₁, 10₂, 10₃, 10₄ abgegriffen werden, summiert werden. Ebenso könnte eine gemeinsame Elektrode vorgesehen werden, die in Kontakt mit allen Messelementen 10₁, 10₂, 10₃, 10₄ steht und über die das Signal aller Messelemente 10₁, 10₂, 10₃, 10₄ gemeinsam erfasst wird. Ebenso können einige Messelemente einer gemeinsamen Elektrode zugeordnet werden und andere Messelemente mit separaten Elektroden versehen werden. Dies ist davon abhängig, welche verschiedenen Signale mit dem Sensorelement erfasst werden sollen.

Alternativ zu dem in Fig.2 dargestellten Sensorelement kann ein nicht dargestelltes Sensorelement sechs, insbesondere gleich große, Messelemente aufweisen, die gleichmäßig um das Durchgangsloch angeordnet sind. Ihre Vorzugsrichtungen, die ebenfalls parallel zu der gemeinsamen Ebene der Messelemente sind, erstrecken sich radial von dem Durchgangsloch und weisen einen Winkel von 60 Grad zu den benachbarten Vorzugsrichtungen auf.

Wiederum alternativ hierzu erstrecken sich in einer erfindungsgemäßen Ausführungsform zwei der sechs Vorzugsrichtungen radial von dem Durchgangsloch und die vier übrigen Vorzugsrichtungen sind tangential zum Durchgangsloch angeordnet. Hiermit kann vorteilhaft ein übertragenes Drehmoment gemessen und ein Temperatureintrag bewertet werden.

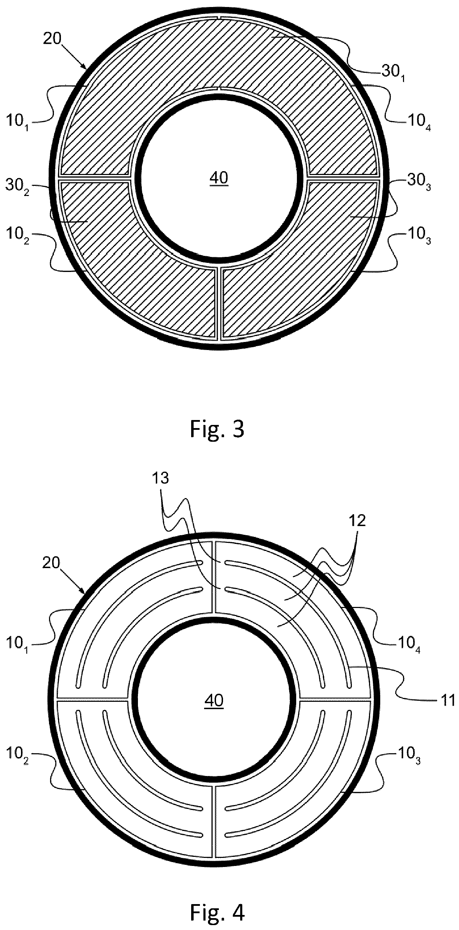

Fig. 3 zeigt eine exemplarische Elektrodenkonfiguration für das Sensorelement aus Fig. 2. Die Messelemente 10₁, 10₂, 10₃, 104 in Fig. 3 entsprechen den Messelementen 10₁, 10₂, 10₃, 10₄ aus Fig. 2. Die Messelemente 10₁ und 10₄ sind einer gemeinsamen Elektrode 30₁ zugeordnet, die auf der flächigen Oberseite der Messelemente 10₁ und 10₄ angeordnet ist. Somit werden an den Messelementen 10₁ und 10₄ erzeugte Signale auf die gemeinsame Elektrode 30₁ summiert und gemeinsam erfasst. Dem Messelement 10₂ ist eine separate Elektrode 30₂ zugeordnet, ebenso ist dem Messelement 10₃ eine separate Elektrode 30₃ zugeordnet. Mit dieser Konfiguration kann über die Elektrode 30₁ ein Signal abgegriffen werden, das einer in Fig. 3 nach oben wirkenden Radialkraft entspricht. Die Summe der Signale aller dreier Elektroden 30₁, 30₂, 30₃ ist geeignet, einen Temperatureintrag an einem in dem Durchgangsloch 40 befindlichen Element zu erfassen.

Fig. 4 zeigt eine Modifikation des in Fig. 2 dargestellten Sensorelements. Die Messelemente 10₁, 10₂, 10₃, 10₄ weisen eine Vielzahl von Ausnehmungen 11 auf, die die Messelemente 10₁, 10₂, 10₃, 10₄ in Messbereiche 12 unterteilen, die durch Verbindungsbereiche 13 miteinander verbunden sind. In Fig. 4 sind eine Ausnehmung 11, sowie die Messbereiche 12 und Verbindungsbereiche 13 des Messelements 10₄ repräsentativ mit Bezugszeichen versehen. Die Ausnehmungen 11 erstrecken sich vorzugsweise durch die gesamte Dicke der Messelemente 10₁, 102, 10₃, 10₄. Durch die Unterteilung der Messelemente 10₁, 10₂, 10₃, 10₄ in Messbereiche 12 mittels der Ausnehmungen 11 können mechanische Spannungen, die sich in den Messelementen 10₁, 10₂, 10₃, 10₄ aufbauen, über die durch die Ausnehmungen 11 gebildeten Lücken zwischen den Messbereichen 12 effektiv abgebaut werden. Zudem werden durch die mittels der Ausnehmungen 11 bewirkte Strukturierung der Messelemente 10₁, 10₂, 10₃, 10₄ Eigenspannungen reduziert, die ebenfalls die Rissbildung bei Beaufschlagung der Messelemente 10₁, 10₂, 10₃, 10₄ mit einer Kraft begünstigen. Durch das Vorsehen der Verbindungsbereiche 13 bleibt die strukturelle Integrität der Messelemente 10₁, 10₂, 10₃, 10₄ gewahrt, so dass sich keine Schwierigkeiten bei der Handhabung der Messelemente 10₁, 10₂, 10₃, 10₄, beispielsweise beim Einbau in einen Sensor, ergeben.

Die Ausnehmungen 11 sind schlitzartig ausgebildet und weisen eine Erstreckungsrichtung auf (in Fig. 4 erstrecken sich die Ausnehmungen 11 auf zum Durchgangsloch 40 konzentrischen Kreislinien), die wesentlich länger ist als die anderen Erstreckungsrichtungen der Ausnehmungen 11. Dadurch kann eine effektive Unterteilung der Messelemente 10₁, 10₂, 10₃, 10₄ in Messbereiche 12 bei minimalem Materialaustrag bei der Ausbildung der Ausnehmungen 11 erreicht werden.

Die Form der schlitzartigen Ausnehmungen 11 unterliegt keiner besonderen Einschränkung. In dem in Fig. 4 gezeigten Ausführungsbeispiel sind die Ausnehmungen 11 kurvenförmig ausgebildet. Es sind auch andere Formen der Ausnehmungen 11 möglich, beispielsweise linien-, kurven-, wellen- oder mäanderförmige Formen.

Die in Fig. 4 gezeigte Modifikation der Messelemente 10₁, 10₂, 10₃, 10₄ kann auch nur für einzelne Messelemente verwendet werden. Ebenso kann die in Fig. 4 gezeigte Modifikation der Messelemente auf beliebige andere, in dieser Anmeldung beschriebene Messelemente übertragen werden.

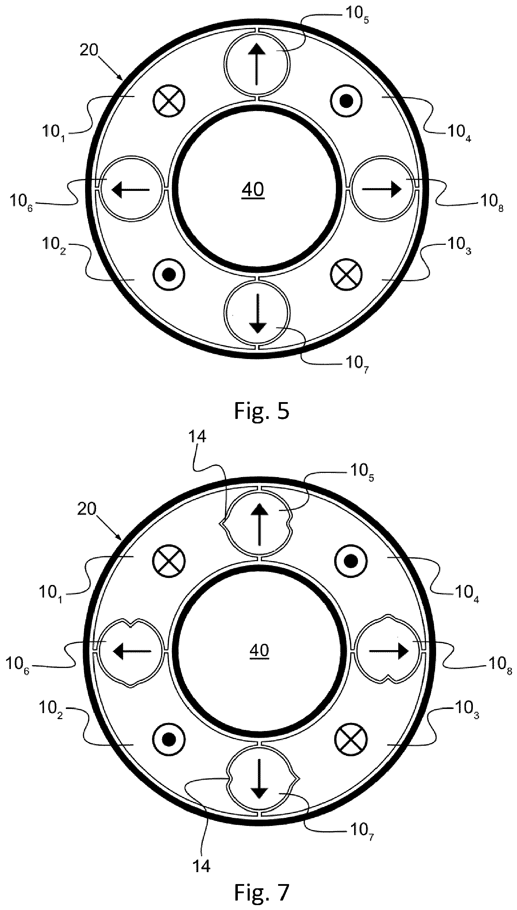

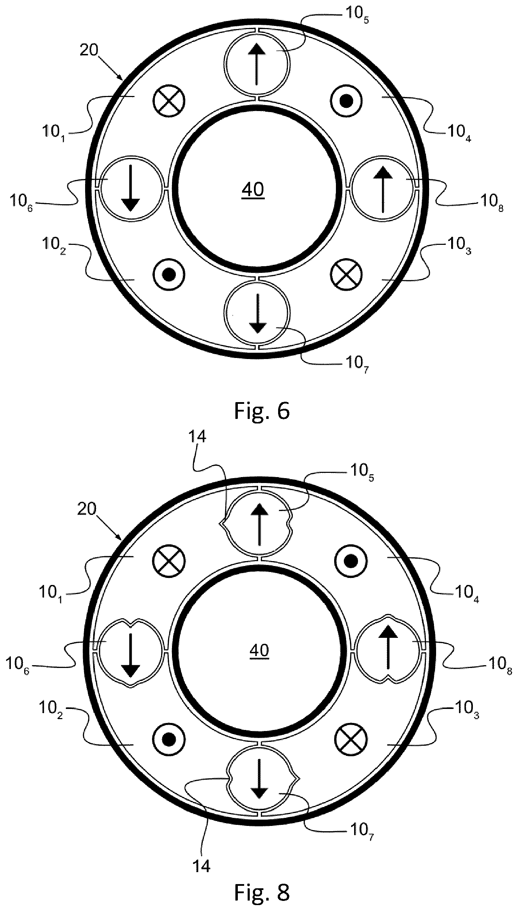

Fig. 5 und Fig. 6 zeigen eine schematische Ansicht eines strukturierten, piezoelektrischen Sensorelements gemäß zwei weiteren Ausführungsbeispielen der vorliegenden Erfindung. Das Sensorelement weist jeweils acht Messelemente 10₁, 10₂, 10₃, 10₄, 10₅, 10₆, 10₇, 10₈ auf, die gemeinsam in einem Gehäuseelement 20 mit Durchgangsloch 40 angeordnet sind. Die Vorzugsrichtungen der Messelemente 10₁, 10₂, 10₃, 10₄ erstrecken sich in einer Richtung senkrecht zu der Ebene, in der die Messelemente 10₁, 10₂, 10₃, 10₄, 10₅, 10₆, 10₇, 10₈ angeordnet sind. Die Vorzugsrichtungen der Messelemente 10₅, 10₆, 10₇, 10₈ erstrecken sich in einer Richtung parallel zu der Ebene, in der die Messelemente 10₁, 10₂, 10₃, 10₄, 10₅, 10₆, 10₇, 10₈ angeordnet sind. Es ergibt sich somit eine Anordnung, in der die Vorzugsrichtung der um das Durchgangsloch angeordneten Messelemente 10₁, 10₂, 10₃, 10₄, 10₅, 10₆, 10₇, 10₈ abwechselnd in einer Richtung senkrecht zu der Erstreckungsebene des Sensorelements und in einer Richtung parallel zu Erstreckungsebene des Sensorelements ausgerichtet sind.

Mit dem in Fig. 5 gezeigten Sensorelement lassen sich die auf die Messelemente 10₅, 10₆, 10₇, 10₈ wirkenden Radialkräfte erfassen. Die Summe der Signale der Messelemente 10₅, 10₆, 10₇, 10₈ gibt die an dem Element wirkende Radialkraft an. Durch Summierung der vier Signale wird die Messempfindlichkeit und die Signalstärke deutlich erhöht. Die Signale der Messelemente 10₁, 10₂, 10₃, 10₄ geben Krafteinwirkungen senkrecht zu der Bildebene an. Wird das Sensorelement beispielsweise in einem Sensor verwendet, der mit dem Durchgangsloch 40 auf eine Motorwelle aufgesetzt ist und an einem Gehäuse des Motors fixiert ist, kann mit dem Summensignal der Messelemente 10₅, 10₆, 10₇, 10s die thermische Ausdehnung der Motorwelle bestimmt werden. Mittels der Signale der Messelemente 10₁, 10₂, 10₃, 10₄ können Vibrationen des Gehäuses ebenso wie Unwuchten des Motors gemessen werden. Es kann somit ein Sensor geschaffen werden, der sowohl bei der Motorsteuerung als auch bei der Fehlerdiagnose eingesetzt werden kann.

Die Form der größeren Messelemente 10₁, 10₂, 10₃, 10₄ in Fig. 5 ist so ausgebildet, dass die größeren Messelemente 10₁, 10₂, 10₃, 10₄ die Position der kleineren Messelemente 10₅, 10₆, 10₇, 10₈ in dem Gehäuseelement 20 vollständig festlegen, wenn sie zuerst eingesetzt werden. Damit können die Sensorelemente 10₁, 10₂, 10₃, 10₄ als Positionierungshilfe für die Sensorelemente 10₅, 10₆, 10₇, 10s genutzt werden.

Das in Fig. 6 gezeigte Sensorelement entspricht bis auf die Vorzugsrichtungen der Messelemente 10₆ und 10₈ dem Sensorelement gemäß Fig. 5. Die Vorzugsrichtungen der Messelemente 10₆ und 10₈ sind tangential zum Durchgangsloch ausgerichtet. Somit lassen sich eine Vielzahl von Kraftrichtungen an einem in dem Durchgangsloch 40 angeordneten Element erfassen. Die Summe der Signale der Messelemente 10₅ und 10₇ gibt die an dem Element wirkende Radialkraft an. Die Summe der Signale der Messelemente 10₆ und 10₈ gibt die an dem Element wirkende Tangentialkraft an. Durch Summierung der Signale wird jeweils die Messempfindlichkeit und die Signalstärke deutlich erhöht. Die Signale der Messelemente 10₁, 10₂, 10₃, 10₄ geben Krafteinwirkungen senkrecht zu der Bildebene an. Wird das Sensorelement beispielsweise in einem Sensor verwendet, der mit dem Durchgangsloch 40 auf eine Motorwelle aufgesetzt ist und an einem Gehäuse des Motors fixiert ist, kann mit dem Summensignal der Messelemente 10₆ und 10₈ das Drehmoment des Motors gemessen werden bzw. die Kraft, mit der sich der Motor beim Betrieb am Gehäuse abstützt. Mittels der Signale der Messelemente 10₁, 10₂, 10₃, 10₄ können Vibrationen des Gehäuses ebenso wie Unwuchten des Motors gemessen werden. Es kann somit ein Sensor geschaffen werden, der sowohl bei der Motorsteuerung als auch bei der Fehlerdiagnose eingesetzt werden kann.

Die Form der Messelemente kann weiterhin so ausgebildet werden, dass durch die eingesetzten Messelemente sowohl die Position als auch die Orientierung benachbarter Messelemente festlegt ist. Eine solche Ausführungsform ist in Fig. 7 und Fig. 8 gezeigt. Die Messelemente 10₁, 10₂, 10₃, 10₄, 10₅, 10₆, 10₇, 10s weisen an den Seiten, die an benachbarte Messelemente angrenzen, jeweils eine Ausrichtungshilfe 14 auf. Die Ausrichtungshilfen 14 sind durch Ein- und Ausbuchtungen gebildet, wobei die Ausrichtungshilfen 14 von aneinander grenzenden Messelementen aufeinander abgestimmt sind. Dadurch wird es möglich, die relative Orientierung und Position benachbarter Messelemente durch das formschlüssige Aneinanderfügen der jeweiligen Ausrichtungshilfen 14 eindeutig festzulegen.

In den in Fig. 7 und Fig. 8 gezeigten Ausführungsbeispielen weisen die Messelemente 10₁ und 10₃ spitz zulaufende Ausrichtungshilfen 14 auf, die sich in ihrer Form von den rund zulaufenden Ausrichtungshilfen 14 der Messelemente 10₂ und 10₄ unterscheiden. Die Messelemente 10₅, 10₆, 10₇, 10₈ weisen jeweils sowohl spitz zulaufende als auch rund zulaufende Ausrichtungshilfen 14 auf, die jeweils formschlüssig in die Ausrichtungshilfen 14 der Messelemente 10₁, 10₂, 10₃, 10₄ eingreifen. Dadurch wird relative Positionierung und Orientierung der Messelemente zueinander in dem Gehäuseelement 20 durch die Ausrichtungshilfen 14 festgelegt.

Durch die Verwendung der Ausrichtungshilfen 14 kann sichergestellt werden, dass die Orientierung der Messelemente beim Zusammenbau des Sensorelements korrekt eingehalten wird. Dadurch kann eine korrekte Ausrichtung der Vorzugsrichtungen aller Messelemente sichergestellt werden.

In den vorstehend beschriebenen Ausführungsbeispielen werden die den Messelementen zugeordneten Elektroden vorzugsweise auf einer der flächigen Seiten der Messelemente angeordnet. Je nach Vorzugsrichtung der Messelemente kann es jedoch vorteilhaft oder erforderlich sein, die Elektroden an einer der schmalen Seiten der flächigen Messelemente anzuordnen oder an den schmalen Seiten zusätzliche Elektroden zur Signalerfassung vorzusehen. Dabei können auch entsprechende Ausnehmungen in den Messelementen für eine mit den Elektroden zu verbindende Ladungsableitung vorgesehen werden.

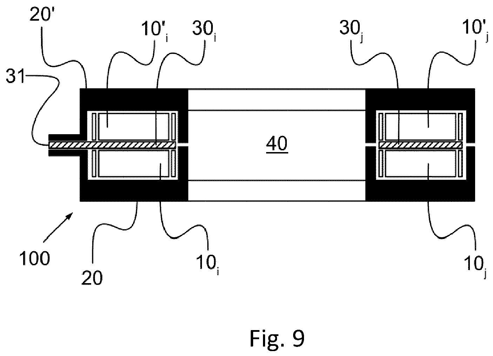

Fig. 9 zeigt einen Schnitt eines Sensors 100 gemäß einem Ausführungsbeispiel der vorliegenden Erfindung. Der Sensor 100 weist ein Sensorelement mit Messelementen 10ᵢ, 10ⱼ auf, das in einem Gehäuseelement 20 angeordnet ist. Die Konfiguration des Sensorelements mit den exemplarisch dargestellten Messelementen 10ᵢ, 10ⱼ entspricht einer der in Fig. 1 bis Fig. 8 gezeigten Konfigurationen.

Über dem in dem Gehäuseelement 20 angeordneten Sensorelement befindet sich ein weiteres Sensorelement mit Messelementen 10'ᵢ, 10'ⱼ, das in einem Gehäuseelement 20' angeordnet ist.

Zwischen den Sensorelementen ist eine Schicht von Elektroden angeordnet, wobei in Fig. 9 exemplarisch Elektroden 30ᵢ, 30ⱼ gezeigt sind. Die Elektroden 30ᵢ, 30ⱼ sind mit Anschlüssen versehen, die aus dem Gehäuse des Sensors 100 herausgeführt sind. In Fig. 9 ist exemplarisch ein Anschluss 31 der Elektrode 30ᵢ gezeigt. Der Anschluss 31 weist eine Abschirmung zur Verbesserung der Signalqualität auf. Die einander gegenüberliegenden Sensorelemente mit den dazwischen angeordneten Elektroden bilden ein Paar von Sensorelementen, das aufeinander abgestimmt ist, indem jedem Messelement 10ᵢ, 10ⱼ des unteren Sensorelements ein entsprechendes Messelement 10'ᵢ, 10'ⱼ des oberen Sensorelements zugeordnet ist, das dem unteren Messelement 10ᵢ, 10ⱼ in Position und Form entspricht. Die Messignale, die an den Paaren von Messelementen erzeugt werden, werden jeweils auf die gemeinsame, zwischenliegende Elektrode summiert.

Beim Zusammenbau des Sensors 100 wird zunächst ein Gehäuseelement 20 bereitgestellt. In das Gehäuseelement 20 wird ein Sensorelement eingebracht, indem die Messelemente 10₁, ..., 10ᵢ in das Gehäuseelement 20 eingelegt werden. Anschließend wird auf das Sensorelement eine Elektrodenschicht mit Elektroden 30; 30ᵢ, ..., 30ᵢ aufgebracht. Beispielsweise wird die Elektrodenschicht in Gestalt einer strukturierten Metallfolie mit bereitgestellt und auf das Sensorelement aufgelegt. Anschließend wird auf die Elektrodenschicht ein zweites Sensorelement aufgelegt, dessen Konfiguration dem in dem Gehäuseelement 20 befindlichen Sensorelement entspricht. Anschließend wird ein zweites Gehäuseelement 20' aufgelegt und mit dem unteren Gehäuseelement verbunden, so dass das Paar von Sensorelementen mit der dazwischenliegenden Elektrodenschicht zwischen den zwei Gehäuseelementen 20, 20' vorgespannt ist. dazwischenliegenden Elektrodenschicht außerhalb der Gehäuseelemente 20, 20' erfolgen, beispielsweise mittels Thermokompression. In diesem Fall wird die vorgespannte Einheit aus Sensorelementen und Elektrodenschicht anschließend in ein Gehäuse eingebracht.

Wird eine strukturierte Elektrodenschicht verwendet, beispielsweise in Form einer strukturierten Folie, können zur einfacheren Handhabung zwischen den Elektroden Brücken in der Elektrodenschicht vorgesehen sein, die die jeweiligen Elektroden in ihrer Position halten. Diese Brücken können nach dem Vorspannen dann entfernt werden. Weiterhin ist es möglich, die Position der Sensorelemente und der Messelemente innerhalb der Sensorelemente und/oder die Position der Elektroden mittels geeigneter Positioniervorrichtungen festzulegen. Beispielsweise könnten die Gehäuseelemente 20, 20' entsprechende Stege aufweisen, die als Positioniervorrichtungen für die Sensorelemente dienen. Nach dem Positionieren der Sensorelemente bzw. nach dem Zusammensetzen der Sensorelemente mit zwischenliegender Elektrodenschicht können die Elemente vergossen werden, um die Positionierung der Elemente innerhalb des Sensors zu fixieren.

Der in Fig. 9 gezeigte Aufbau des Sensors 100 ist rein beispielhaft. Die erfindungsgemäßen Sensorelemente können auch in einen erfindungsgemäßen Sensor eingesetzt werden, dessen Aufbau sich von dem in Fig. 9 gezeigten Aufbau unterscheidet. Beispielsweise können weitere Schichten von Messelementen, Elektroden oder Isolierschichten in dem Sensor vorgesehen sein. Für die Erzielung der erfindungsgemäßen Vorteile ist entscheidend, dass wenigstens ein Sensorelement in dem Sensor vorhanden ist, das mehrere, in einer gemeinsamen Ebene angeordnete Messelemente mit einer definierten Ausrichtung der Vorzugsrichtungen aufweist.

### Bezuaszeichenliste:

- 10₁, ..., 10ᵢ: Messelement
- 10'₁, ..., 10'ᵢ: Messelement
- 11: Ausnehmung
- 12: Messbereich
- 13: Verbindungsbereich
- 14: Ausrichtungshilfe

- 20, 20': Gehäuseelement

- 30; 30₁, ..., 30ᵢ: Elektrode
- 30'; 30'₁, ..., 30'ᵢ: Elektrode
- 31: Anschluss

- 40: Durchgangsloch

- 100: Sensor

## Patentansprüche

1. Strukturiertes, piezoelektrisches Sensorelement, aufweisend mehrere piezoelektrische, vorzugsweise monokristalline, flächig ausgebildete Messelemente (10₁, ..., 10ᵢ), die zwischen Gehäuseelementen (20, 20') eines piezoelektrischen Sensors (100) lagerbar und mechanisch vorspannbar sind, wobei die Messelemente (10₁, ..., 10ᵢ) in einer gemeinsamen Ebene angeordnet sind, und wobei die Vorzugsrichtungen der Messelemente (10₁, ..., 10ᵢ) eine definierte Ausrichtung relativ zu der gemeinsamen Ebene, in der die Messelemente (10₁, ..., 10ᵢ) angeordnet sind, und relativ zueinander aufweisen,
wobei das Sensorelement eine Lochscheibe mit einem Durchgangsloch (40) ausbildet und die Messelemente (10₁, ..., 10ᵢ) um das Durchgangsloch (40) angeordnet sind,
**dadurch gekennzeichnet, dass**
die Vorzugsrichtungen mindestens zwei der Messelemente (10₁, ..., 10ᵢ) sich radial von dem Durchgangsloch (40) erstrecken.

2. Sensorelement nach Anspruch 1, wobei die Vorzugsrichtungen aller Messelemente (10₁, ..., 10ᵢ) sich radial von dem Durchgangsloch (40) erstrecken.

3. Sensorelement nach Anspruch 1 oder 2, wobei die Messelemente (10; 10₁, ..., 10ᵢ) so geformt sind, dass sie derart aneinander angrenzend anordenbar sind, dass die Orientierung und/oder Position der Messelemente (10; 10₁, ..., 10ᵢ) jeweils durch die angrenzenden Messelemente (10; 10ᵢ, ..., 10ᵢ) festgelegt ist.

4. Sensorelement nach einem der vorhergehenden Ansprüche, wobei die Vorzugsrichtungen der Messelemente (10₁, ..., 10ᵢ) sich parallel zu der gemeinsamen Ebene erstrecken, in der die Messelemente (10ᵢ, ..., 10ᵢ) angeordnet sind.

5. Sensorelement nach einem der vorhergehenden Ansprüche, aufweisend zwei Messelemente (10ᵢ, 10₂), deren Vorzugsrichtungen nicht parallel zueinander, insbesondere senkrecht zueinander, sind.

6. Sensorelement nach einem der vorhergehenden Ansprüche, wobei die Messelemente (10₁, ..., 10ᵢ) mindestens zwei Vorzugsrichtungen parallel zu der gemeinsamen Ebene, in der die Messelemente (10₁, ..., 10ᵢ) angeordnet sind, und mindestens eine Vorzugsrichtung senkrecht zu der gemeinsamen Ebene, in der die Messelemente (10₁, ..., 10ᵢ) angeordnet sind, aufweisen.

7. Sensorelement nach einem der vorhergehenden Ansprüche, wobei mindestens ein Messelement (10₁, ..., 10ᵢ) eine oder mehrere Ausnehmungen (11) zum Abbau von mechanischen Spannungen aufweist, die das Messelement (10₁, ..., 10ᵢ) in Messbereiche (12) unterteilen, die durch Verbindungsbereiche (13) miteinander verbunden sind.

8. Sensorelement nach einem der vorhergehenden Ansprüche, wobei die Messelemente (10₁, ..., 10ᵢ) aus Galliumorthophosphat oder Lithiumniobat oder CTGS gebildet sind.

9. Piezoelektrischer Sensor (100), aufweisend ein Sensorelement nach einem der vorhergehenden Ansprüche, das zwischen zwei Sensorgehäuseelementen (20, 20') gelagert und zwischen den Sensorgehäuseelementen (20, 20') vorgespannt ist.

10. Sensor (100) nach Anspruch 9, wobei die Messelemente (10; 10₁, ..., 10ᵢ) in Kontakt mit einer Elektrode (30; 30₁, ..., 30ᵢ) zur Abnahme von Messsignalen sind.

11. Sensor (100) nach Anspruch 9 oder 10, aufweisend ein Paar von Sensorelementen nach einem der Ansprüche 1 bis 8, die übereinander angeordnet sind, wobei eine Schicht von Elektroden (30; 30₁, ..., 30ᵢ) zwischen den Sensorelementen angeordnet ist.

12. Verwendung eines Sensorelements nach Anspruch 5 zur Messung von Scher- und Radialkräften an einem Element, das sich durch das Durchgangsloch (40) erstreckt.

13. Verwendung eines Sensorelements nach Anspruch 1 zur Messung eines Temperatureintrags eines Elements, das sich durch das Durchgangsloch (40) erstreckt.

14. Verwendung eines Sensorelements nach Anspruch 1 zur Messung mehrerer Kraftkomponenten in der Ebene, in der die Messelemente (10; 10₁, ..., 10ᵢ) angeordnet sind.

15. Verwendung eines Sensorelements nach Anspruch 6 zur Messung von Scher-, Radial- und/oder Axialkräften, und/oder einem Temperatureintrag eines Elements, das sich durch das Durchgangloch (40) erstreckt.
